# EUROPÄISCHE PATENTSCHRIFT

(11) **EP 4 533 113 B1**
(45) Veröffentlichungstag und Bekanntmachung des Hinweises auf die Patenterteilung: **30.09.2026**
(21) Anmeldenummer: 23727552.4
(22) Anmeldetag: 17.05.2023
(51) Int. Cl.: G01R 33/24, G01R 33/32

(54) **MAGNETFELDGRADIOMETER**
MAGNETIC FIELD GRADIOMETER
GRADIOMÈTRE DE CHAMP MAGNÉTIQUE

(30) Priorität: 31.05.2022 DE 102022205468
(43) Veröffentlichungstag der Anmeldung: 09.04.2025
(73) Patentinhaber: Quantum Brilliance GmbH, 70565 Stuttgart (DE)
(72) Erfinder: SCHILLER, Ferdinand, 70825 Korntal-Muenchingen (DE); ROELVER, Robert, 75365 Calw (DE); JAG-LAUBER, Katharina, 73650 Winterbach (DE)
(74) Vertreter: DREISS Patentanwälte PartG mbB
(86) Internationale Anmeldenummer: PCT/EP2023/063408
(87) Internationale Veröffentlichungsnummer: WO 2023/232490

(56) Entgegenhaltungen:
- MASUYAMA YUTA ET AL: "Gradiometer Using Separated Diamond Quantum Magnetometers", SENSORS, vol. 21, no. 3, 2 February 2021 (2021-02-02), pages 977, XP055954870, DOI: 10.3390/s21030977
- FESCENKO ILJA ET AL: "Diamond magnetometer enhanced by ferrite flux concentrators", PHYSICAL REVIEW RESEARCH, vol. 2, no. 2, 24 June 2020 (2020-06-24), XP055936990, DOI: 10.1103/PhysRevResearch.2.023394
- S. M. BLAKLEY ET AL: "Fiber-optic vectorial magnetic-field gradiometry by a spaiotemporal differential optical detection of magnetic resonance in nitrogen-vacancy centers in diamond", OPTICS LETTERS, vol. 41, no. 9, 27 April 2016 (2016-04-27), US, pages 2057, XP055680838, ISSN: 0146-9592, DOI: 10.1364/OL.41.002057

## Beschreibung

Die vorliegende Erfindung betrifft ein Magnetfeldgradiometer zur Bestimmung eines Magnetfeldgradienten, umfassend: mindestens eine Anregungslichtquelle zur Emission von Anregungslicht, zwei räumlich beabstandete Messbereiche zur Magnetfeld-Messung, die Farbzentren in einem Diamant, bevorzugt NV-Zentren, aufweisen, die bei einer Anregung mit dem Anregungslicht Fluoreszenzlicht emittieren, einen ersten Detektor zur Detektion des Fluoreszenzlichts aus dem ersten Messbereich, einen zweiten Detektor zur Detektion des Fluoreszenzlichts aus dem zweiten Messbereich, einen ersten Mikrowellenemitter zum Beaufschlagen des ersten Messbereichs mit einem ersten Mikrowellenfeld, einen zweiten Mikrowellenemitter zum Beaufschlagen des zweiten Messbereichs mit einem zweiten Mikrowellenfeld, sowie eine Auswerteeinrichtung, die zur Bestimmung des Magnetfeldgradienten anhand des detektierten Fluoreszenzlichts aus dem ersten Messbereich und anhand des detektierten Fluoreszenzlichts aus dem zweiten Messbereich ausgebildet ist.

Hochempfindliche Magnetometer können unter anderem dafür genutzt werden, magnetische Signale von Gehirn- oder Nervenaktivität lokal aufgelöst aufzunehmen um auf diese Weise neuartige Mensch-Maschine Schnittstellen zur Steuerung von Prothesen, von Exoskeletten oder von Maschinen zu nutzen. Da das Nutzsignal menschlicher Nervenaktivität mit seiner Amplitude ggf. unterhalb des magnetischen Umgebungsrauschens liegt, müssen für die oben beschriebenen Anwendungen Lösungen zur Unterdrückung des Umgebungsrauschens gefunden werden. Eine solche Lösung ist die Verwendung gradiometrischer Sensorkonzepte, bei denen der Messbereich eines ersten Magnetometers direkt an der Magnetfeldquelle platziert ist und der Messbereich eines zweiten Magnetometers mit einem definierten Abstand zum ersten Messbereich von der Magnetfeldquelle entfernt angeordnet ist. Das Magnetometer mit dem weiter entfernten zweiten Messbereich zeichnet dabei nur das Umgebungsrauschen auf, während der Messbereich des Magnetometers, das näher an der Signalquelle angeordnet ist, zusätzlich zum Umgebungsrauschen das Nutzsignal detektiert. Durch Subtraktion des durch das erste Magnetometer aufgezeichneten Rauschsignals vom Signal des zweiten Magnetometers erhält man ein Signal, das nur noch das Nutzsignal enthält, und das im Sinne dieser Anmeldung als Magnetfeldgradient bezeichnet wird. Verglichen mit der Magnetfeldmessung mittels eines einzelnen Magnetometers ermöglicht es ein Magnetfeldgradiometer, das Umgebungsrauschen, das sich auf beide Magnetometer gleich auswirkt, zu eliminieren bzw. zu unterdrücken.

Magnetfeldgradiometer der eingangs beschriebenen Art und entsprechende Magnetometer basieren auf einer magnetfeldabhängigen Veränderung der Fluoreszenz von Farbzentren, typischerweise von NV-Zentren, in einem Diamant in Gegenwart eines magnetischen Wechselfeldes. Genauer gesagt handelt es sich hierbei um eine optische Detektion einer magnetischen Resonanz (ODMR). Die Prinzip einer solchen Detektion ist in dem Artikel "Nanoscale imaging magnetometry with diamond spins under ambient conditions" von G. Balasubramian et al., Nature 455, 648 (2008) beschrieben. Dieses Prinzip wird im Folgenden am Beispiel eines NV-Zentrums erläutert.

Bei einem NV-Zentrum handelt es sich um ein spezielles Farbzentrum in einem Diamantkristallgitter, das aus einem Stickstoff-Atom und einer benachbarten Fehlstelle besteht. Genauer wird im Rahmen dieser Anmeldung unter einem NV-Zentrum ein negativ geladenes NV-Zentrum verstanden. Die Magnetfeldgradiometer sind ferner zur Messung an einer Vielzahl von NV-Zentren ausgebildet (sogenannte Ensemble-Magnetometrie).

Die Energieniveaus eines NV-Zentrums umfassen einen Grundzustand und einen angeregten Zustand in Form jeweils eines Tripletts. Die jeweils drei Zustände jedes Tripletts unterscheiden sich in ihrer magnetischen Spinquantenzahl, *m*_{S} = -1,0, + 1. Die *m*_{S} =± 1 Zustände sind aufgrund der Spin-Spin-Wechselwirkung höherenergetisch als der *m*_{S} = 0 Zustand. Ohne Magnetfeld sind die *m*_{S} =± 1 Zustände entartet (bei Vernachlässigung der Hyperfeinstruktur), haben also die gleiche Energie. **In** Gegenwart eines Magnetfelds ist aufgrund des Zeeman-Effekts die Entartung der *m*_{S} =± 1 Zustände hingegen proportional zum Magnetfeld aufgehoben.

Mittels Einstrahlung von Anregungslicht im grünen Wellenlängenbereich können die NV-Zentren aus dem Grundzustand in den angeregten Zustand gepumpt werden. Die Rückkehr in den Grundzustand erfolgt teilweise unter Emission von rotem Fluoreszenzlicht. Die Intensität dieses Fluoreszenzlichts hängt von der Populationsverteilung zwischen den *m*_{S} = -1,0, + 1 Zuständen des Triplett-Grundzustands ab. Durch Wechselwirkung mit einem resonanten Mikrowellenfeld kann diese Populationsverteilung beeinflusst werden. Genauer kommt es bei einem Mikrowellenfeld mit den Frequenzen *f₊* und *f₋*, entsprechend den Übergängen zwischen dem *m*_{S} = 0 und dem *m*_{S} = +1 Zustand beziehungsweise dem *m*_{S} = -1 Zustand, zu einem Abfall der detektierten Intensität des Fluoreszenzlichts.

Zur Bestimmung eines Magnetfelds mittels eines entsprechenden Magnetometers wird nun die Frequenz des Mikrowellenfelds variiert. **In** Abhängigkeit von der Frequenz des Mikrowellenfelds weist die gemessene Intensität des Fluoreszenzlichts Minima, auch als "Dip" beziehungsweise "Dips" bezeichnet, bei den Frequenzen *f*_{±} auf. Über die Lage dieser Minima wird das Magnetfeld bestimmt.

Die Frequenzen *f₊* und *f₋* ergeben sich dabei aus der Formel ${f}_{\pm } = D \left(T, p\right) \pm {γ}_{NV} {B}_{0} ,$ siehe beispielsweise den Artikel "Integrated and portable magnetometer based on nitrogen-vacancy ensembles in diamond" von F. Stürner et al., arXiv:2012.01053. Hierbei ist *D(T,p)* die Aufspaltung zwischen dem *m*_{S} = 0 Zustand und den *m*_{S} =± 1 Zuständen des Triplett-Grundzustands, die von der Temperatur *T* und dem Umgebungsdruck p abhängig ist, γ_{NV} das gyromagnetische Verhältnis des NV-Zentrums und *B*₀ die Projektion des Magnetfelds auf die entsprechende Achse des NV-Zentrums.

Im Fall eines Magnetfeldgradiometers erfolgen derartige Messungen in zwei räumlich beabstandeten Messbereichen, in welchen jeweils NV-Zentren oder andere Diamant-Farbzentren angeordnet sind. Aus einem Vergleich der Minima des Fluoreszenzlichts aus dem ersten und dem zweiten Messbereich und dem Abstand der Messbereiche wird dann der Magnetfeldgradient bestimmt (s.o.).

Durch die Bauweise derartiger Magnetfeldgradiometer kann es allerdings leicht zu einem Temperaturunterschied und/oder zu einem Druckunterschied zwischen den zwei Magnetometern beziehungsweise zwischen den beiden Messbereichen kommen. Durch die Temperatur- und Druckabhängigkeit der Frequenzen *f*_{±} kann ein derartiger Temperaturunterschied bzw. Druckunterschied den ermittelten Magnetfeldgradienten verfälschen.

In dem Artikel "Diamond magnetometer enhanced by ferrite flux concentrators" von I. Fescenko et al., Physical Review Research 2, 023394 (2020), ist ein Magnetometer beschrieben, bei dem eine Doppelresonanz-Technik verwendet wird, um den Effekt einer thermischen Verschiebung der Energielevel der NV-Zentren zu kompensieren. Zu diesem Zweck werden zwei frequenzmodulierte Mikrowellensignale, die zwei um π zueinander phasenversetzte Frequenzanteile aufweisen, kombiniert und von einem Mikrowellenemitter auf den Diamant-Kristall mit den NV-Zentren eingestrahlt. Das Fluoreszenzlicht der NV-Zentren wird mit einem Fotodetektor detektiert, einem Lock-In-Verstärker zugeführt und dort mit Hilfe eines Referenzsignals demoduliert. Auf diese Weise wird ein Output-Signal des Lock-In-Verstärkers erzeugt, das proportional zur Differenz (*f₊ - f₋*) zwischen den beiden Frequenzen *f₊* und *f*₋ ist und das nicht von der thermischen Verschiebung abhängig ist.

In dem Artikel "Robust high-dynamic-range vector magnetometry with nitrogen-vacancy centers in diamond", H. Clevenson et al., Appl. Phys. Lett. 112, 252406 (2018), ist ein Magnetometer mit einem großen Dynamikbereich beschrieben. Um den großen Dynamikbereich zu realisieren, wird vorgeschlagen, mit Hilfe der Rückkopplung eines Lock-In-Signals die Trägerfrequenz eines Mikrowellensignals zu regeln.

In dem Artikel "Diamond Magnetometry and Gradiometry Towards Subpicotesla dc Field Measurement", Chen Zhang et al., Phys. Rev. Applied 15, 064075 (2021), sind ein Magnetometer und ein Gradiometer beschrieben, bei denen u.a. eine continuouswave (cw) ODMR-Messung in Kombination mit einer Lock-In-Detektion durchgeführt wird, bei der die beiden Mikrowellenfrequenzen der NV-Zentren gleichzeitig angeregt werden.

In dem Artikel "Gradiometer Using Separated Diamond Quantum Magnetometers", Masuyama Yuta et al., Sensors, Bd. 21, Nr. 3, 2. Februar 2021 wird ein Gradiometer mit variabler Sensorlänge beschreiben.

In dem Artikel "Diamond magnetometer enhanced by ferrite flux concentrators", Fescenko Ilja et al., Physical Review Research, Bd. 2, Nr. 2, 1. Juni 2020 wird eine NV-dotierte Diamantmembran zwischen zwei Ferritkegeln in einer Bowtie-Konfiguration beschrieben.

In dem Artikel "Fiber-optic vectorial magnetic-field gradiometry by a spatiotemporal differential optical detection of magnetic resonance in nitrogen vacancy centers in diamond",S. M. Blakley et al., Optics Letters, Bd. 41, Nr. 9, 1. Mai 2016, Seite 2057 wird das Ergänzen der Magnetfeldgradientenmessungen mit einer differentiellen ODMR-Signalerfassung im Zeitbereich beschrieben.

### Aufgabe der Erfindung

Demgegenüber war es Aufgabe der Erfindung, ein Magnetfeldgradiometer der eingangs genannten Art bereitzustellen, das äußere Störeinflüsse, insbesondere Temperatur- und/oder Druckeinflüsse, effektiv kompensieren kann.

### Gegenstand der Erfindung

Diese Aufgabe wird gemäß einem ersten Aspekt gelöst durch ein Magnetfeldgradiometer der eingangs genannten Art, weiter umfassend: einen Signalerzeuger, der ausgebildet ist, ein erstes Mikrowellensignal für den ersten Mikrowellenemitter zu erzeugen, das mindestens zwei um π zueinander phasenversetzte Frequenzanteile aufweist, und ein zweites Mikrowellensignal für den zweiten Mikrowellenemitter zu erzeugen, das mindestens zwei um π zueinander phasenversetzte Frequenzanteile aufweist.

Bei diesem Aspekt der Erfindung wird für jeden Messbereich bzw. für jedes der beiden Magnetometer ein Mikrowellensignal erzeugt, das (mindestens) zwei um π zueinander phasenversetzte Frequenzanteile aufweist. Der Phasenversatz bzw. die relative Modulationsphase von π bzw. von 180° zwischen den beiden Frequenzanteilen führt bei der Demodulation z.B. mit Hilfe eines Lock-In-Verstärkers (s.u.) zu einer Spiegelung der demodulierten Einzelresonanz-Signale in Bezug auf die vertikale Achse. Eine Magnetfeldänderung führt zu einer Verschiebung der Frequenzen der Einzelresonanz-Signale mit dem gleichen Vorzeichen, d.h. die Einzelresonanz-Signale addieren sich konstruktiv. Bei einer Temperatur- und Druckänderung verschieben sich die Frequenzen der Einzelresonanz-Signale mit unterschiedlichem Vorzeichen, sodass diese sich destruktiv addieren. Das demodulierte Doppelresonanz-Signal, dass zur Bestimmung des Magnetfeldes bzw. des Magnetfeldgradienten ausgewertet wird, ist daher nur von Magnetfeldänderungen abhängig und Temperatur- und Drückeinflüsse werden kompensiert.

Der Signalerzeuger weist zur Bildung des ersten Mikrowellensignals einen ersten Leistungsaddierer zum Addieren eines ersten frequenzmodulierten Mikrowellensignals mit zwei um π zueinander phasenversetzten Frequenzanteilen und eines weiteren ersten frequenzmodulierten Mikrowellensignals mit zwei um π zueinander phasenversetzten Frequenzanteilen auf, und der Signalerzeuger weist zur Bildung des zweiten frequenzmodulierten Mikrowellensignals einen zweiten Leistungsaddierer zum Addieren eines zweiten frequenzmodulierten Mikrowellensignals mit zwei um π zueinander phasenversetzten Frequenzanteilen und eines weiteren zweiten frequenzmodulierten Mikrowellensignals mit zwei um π zueinander phasenversetzten Frequenzanteilen auf.

Diese Ausführungsform basiert auf dem gleichen Funktionsprinzip wie die weiter oben beschriebene Ausführungsform. Durch die Verwendung des ersten Leistungsaddierers kann die Leistung des ersten frequenzmodulierten Mikrowellensignals und des weiteren ersten frequenzmodulierten Mikrowellensignals unterschiedlich sein. Entsprechend kann durch die Verwendung des zweiten Leistungsaddierers die Leistung des zweiten frequenzmodulierten Mikrowellensignals und des weiteren zweiten frequenzmodulierten Mikrowellensignals unterschiedlich sein. Das jeweilige frequenzmodulierte Mikrowellensignal adressiert jeweils eine der beiden Magnetfeldresonanzen in dem ersten / zweiten Messbereich, während das weitere frequenzmodulierte Mikrowellensignal die jeweils andere Magnetfeldresonanz in dem ersten / zweiten Messbereich adressiert. Durch die Möglichkeit, bei der Anregung der Einzelresonanzen eine unterschiedliche Leistung vorzugeben, kann bei der Auswertung des jeweiligen demodulierten Fluoreszenzsignals der Unterschied der Skalar-Faktoren (s.u.) der jeweiligen Einzelresonanz-Spektren reduziert werden. Auf diese Weise kann die Unterdrückung von Temperatur- und Druckänderungen in dem demodulierten Doppelresonanz-Signal verstärkt werden.

Bei einer vorteilhaften Weiterbildung ist der Signalerzeuger ausgebildet, die Leistung des ersten frequenzmodulierten Mikrowellensignals und des weiteren ersten frequenzmodulierten Mikrowellensignals unabhängig voneinander einzustellen, und der Signalerzeuger ist ausgebildet, die Leistung des zweiten frequenzmodulierten Mikrowellensignals und des weiteren zweiten frequenzmodulierten Mikrowellensignals unabhängig voneinander einzustellen. Es ist günstig, wenn die Leistung des jeweiligen frequenzmodulierten Mikrowellensignals und des jeweiligen weiteren frequenzmodulierten Mikrowellensignals nicht nur unabhängig voneinander vorgebeben, sondern auch unabhängig voneinander eingestellt werden können. Auf diese Weise kann bei der Auswertung des jeweiligen demodulierten Fluoreszenzsignals der Unterschied der Skalar-Faktoren der jeweiligen Einzelresonanz-Spektren minimiert und die Unterdrückung von Temperatur- und Druckänderungen in dem demodulierten Doppelresonanz-Signal maximiert werden. Die unabhängige Einstellung der Leistung kann auf unterschiedliche Weise erfolgen, wie weiter unten näher beschrieben wird.

Bei einer Weiterbildung weist der Signalerzeuger zur Bildung des ersten frequenzmodulierten Mikrowellensignals einen ersten Frequenzmischer zur Frequenzmischung eines frequenzmodulierten Signals und eines ersten Oszillatorsignals und zur Bildung des weiteren ersten frequenzmodulierten Mikrowellensignals einen weiteren ersten Frequenzmischer zur Frequenzmischung des frequenzmodulierten Signals und eines weiteren ersten Oszillatorsignals auf. Entsprechend weist der Signalerzeuger zur Bildung des zweiten frequenzmodulierten Mikrowellensignals einen zweiten Frequenzmischer zur Frequenzmischung des frequenzmodulierten Signals und eines zweiten Oszillatorsignals und zur Bildung des weiteren zweiten frequenzmodulierten Mikrowellensignals einen weiteren zweiten Frequenzmischer zur Frequenzmischung des frequenzmodulierten Signals und eines weiteren zweiten Oszillatorsignals auf.

Bei dieser Weiterbildung ist typischerweise ein Signalgenerator vorgesehen, der das frequenzmodulierte Signal für alle vier Frequenzmischer erzeugt. Das frequenzmodulierte Signal durchläuft in diesem Fall einen Leistungsteiler, der das frequenzmodulierte Signal auf vier Leistungsanteile aufteilt, die in einem vorgegebenen Verhältnis zueinander stehen. Ein jeweiliger Leistungsanteil des frequenzmodulierten Signals wird einem der vier Frequenzmischer zugeführt. In der Regel sind die vier Leistungsanteile gleich groß, dies ist aber nicht zwingend erforderlich.

Bei einer weiteren Weiterbildung weist der Signalgenerator mindestens einen programmierbaren Abschwächer zur einstellbaren Abschwächung eines jeweiligen Leistungsanteils des frequenzmodulierten Signals auf, das einem der Frequenzmischer zugeführt wird. In diesem Fall kann der Leistungsanteil des frequenzmodulierten Signals, der einem jeweiligen der vier Frequenzmischer zugeführt wird, mit Hilfe des programmierbaren Abschwächers individuell eingestellt werden.

Bei einer weiteren Weiterbildung weist der Signalerzeuger einen ersten Oszillator zur Erzeugung des ersten Oszillatorsignals, bevorzugt mit einstellbarer Leistung, und einen weiteren ersten Oszillator zur Erzeugung des weiteren ersten Oszillatorsignals, bevorzugt mit einstellbarer Leistung, auf. Entsprechend weist der Signalerzeuger einen zweiten Oszillator zur Erzeugung des zweiten Oszillatorsignals, bevorzugt mit einstellbarer Leistung, und einen weiteren zweiten Oszillator zur Erzeugung des weiteren zweiten Oszillatorsignals, bevorzugt mit einstellbarer Leistung, auf. Die Leistung des ersten frequenzmodulierten Mikrowellensignals und des weiteren ersten frequenzmodulierten Mikrowellensignals können unabhängig voneinander eingestellt werden, indem die Leistung des ersten Oszillators bzw. des weiteren ersten Oszillators eingestellt werden. Entsprechendes gilt die für die Leistung des zweiten frequenzmodulierten Mikrowellensignals und des weiteren zweiten frequenzmodulierten Mikrowellensignals.

Bei einer weiteren Ausführungsform weist die Auswerteeinrichtung einen ersten Demodulator zur Bildung eines ersten demodulierten Doppelresonanz-Signals aus dem detektierten Fluoreszenzlicht des ersten Messbereichs und einen zweiten Demodulator zur Bildung eines zweiten demodulierten Doppelresonanz-Signals aus dem detektierten Fluoreszenzlicht des zweiten Messbereichs auf. Wie weiter oben beschrieben wurde, werden beim erfindungsgemäßen Magnetfeldgradiometer beide Magnetresonanzen der NV-Zentren simultan angeregt und ausgelesen. Aus dem ersten / zweiten demodulierten Doppelresonanz-Signal kann die Stärke des Magnetfelds in dem ersten / zweiten Messbereich bestimmt werden.

Bei einer Weiterbildung sind die beiden Demodulatoren jeweils als Lock-In-Verstärker ausgebildet. Die Demodulation der Doppelresonanz-Signale erfolgt bei dieser Weiterbildung mit Hilfe eines Lock-In-Verstärkers. Der jeweilige Lock-In-Verstärker weist typsicherweise einen Frequenzmischer auf, dem das Doppelresonanz-Signal und ein Referenzsignal zugeführt wird. Das aus der Frequenzmischung resultierende Signal durchläuft einen Tiefpassfilter, der ebenfalls Teil des Lock-In-Verstärkers ist. Das demodulierte Doppelresonanz-Signal am Ausgang des Tiefpassfilters weist eine dispersive Form auf und ist um die Resonanzfrequenz linear.

Bei einer Weiterbildung ist die Auswerteeinrichtung ausgebildet, anhand des ersten demodulierten Doppelresonanz-Signals eine magnetfeldabhängige Resonanzabweichung eines ersten Magnetfelds in dem ersten Messbereich zu bestimmen und anhand des zweiten demodulierten Doppelresonanz-Signals eine magnetfeldabhängige Resonanzabweichung eines zweiten Magnetfelds in dem zweiten Messbereich zu bestimmen. Für die Bestimmung der Resonanzabweichung wird typischerweise die Steigung ("skalarer Faktor" α) des linearen Bereichs des demodulierten Doppelresonanzsignals bestimmt. Hierzu wird das jeweilige Mikrowellenfeld zunächst resonant eingestrahlt. Verändert sich die Resonanzfrequenz aufgrund von Magnetfeld-, Temperatur- oder Druckänderungen, so kann die Verstimmung bzw. die Resonanzabweichung Δ von der Resonanzfrequenz anhand des demodulierten Doppelresonanz-Signals *v_{LIA}* wie folgt bestimmt werden: Δ = v_{LIA} / α. Da sich Resonanzabweichungen aufgrund von Temperatur- oder Druckänderungen in den beiden Einzelresonanz-Signalen destruktiv addieren (s.o.) ist die Resonanzabweichung des Doppelresonanz-Signals *v_{LIA}* nur von Veränderungen des Magnetfelds in dem jeweiligen Messbereich abhängig, d.h. es gilt: Δ_{B} = v_{LIA} / α.

Ein weiterer Aspekt der Erfindung betrifft ein Magnetfeldgradiometer der eingangs genannten Art, bei dem der Signalerzeuger einen ersten Leistungsaddierer ausgebildet zur Bildung eines ersten Mikrowellensignals für den ersten Mikrowellenemitter durch Addition von zwei ersten frequenzmodulierten Mikrowellensignalen aufweist, bei dem der Signalerzeuger einen zweiten Leistungsaddierer ausgebildet zur Bildung eines zweiten Mikrowellensignals für den zweiten Mikrowellenemitter durch Addition von zwei zweiten frequenzmodulierten Mikrowellensignalen aufweist, und bei dem die Auswerteeinrichtung einen ersten Leistungsteiler ausgebildet zur Aufteilung der Leistung des detektierten Fluoreszenzlichts aus dem ersten Messbereich auf ein erstes Paar von Demodulatoren und einen zweiten Leistungsteiler ausgebildet zur Aufteilung der Leistung des detektierten Fluoreszenzlichts aus dem zweiten Messbereich auf eine zweites Paar von Demodulatoren aufweist.

Das Magnetfeldgradiometer gemäß dem zweiten Aspekt der Erfindung unterscheidet sich von dem Magnetfeldgradiometer gemäß dem ersten Aspekt der Erfindung dadurch, dass die Doppelresonanz-Anregung mit zwei unterschiedlichen Frequenzbändern erfolgt, die den beiden frequenzmodulierten Mikrowellensignalen entsprechen, deren Leistung in dem jeweiligen Leistungsaddierer addiert wird. Die in den Frequenzbändern enthaltenen Informationen entsprechen jeweils einer Einzelresonanz-Anregung und können mittels jeweils eines der beiden Demodulatoren extrahiert werden. Anhand der beiden demodulierten Einzelresonanz-Signale *V_{LIA+}* bzw *V_{LIA-}* kann auf die weiter oben beschriebene Weise die magnetfeldbedingte Resonanzabweichung *V_{LIA+}*/*α₊* bzw. *V_{LIA-}*/*α*₋bestimmt werden. Wie weiter oben beschrieben wurde, können durch Differenzbildung die Einflüsse von Temperatur- und Druckschwankungen bei der Bestimmung des jeweiligen Magnetfeldes eliminiert werden.

Erfindungsgemäss ist der Signalerzeuger ausgebildet, die ersten frequenzmodulierten Mikrowellensignale mit jeweils unterschiedlichen Trägerfrequenzen zu erzeugen und die zweiten frequenzmodulierten Mikrowellensignale mit jeweils unterschiedlichen Trägerfrequenzen zu erzeugen. Wie weiter oben beschrieben wurde, können durch die Wahl der unterschiedlichen Trägerfrequenzen die beiden Magnetfeldresonanzen der NV-Zentren unabhängig voneinander adressiert werden.

In allen weiter oben beschriebenen Fällen können durch die simultane Anregung und Auswertung beider Magnetfeldresonanzen Magnetfeldänderungen von Änderungen der Temperatur und des Drucks entkoppelt werden, ohne hierbei die Bandbreite des Magnetfeldgradiometers zu limitieren. Die weiter oben beschriebenen Methoden unterscheiden sich im Hinblick auf ihre technische Komplexität sowie auf den Grad der Temperatur- und Druckkompensation.

Weitere Vorteile der Erfindung ergeben sich aus der Zeichnung und ihrer nachfolgenden Beschreibung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: eine schematische Darstellung der Energieniveaus eines NV-Zentrums eines Diamant-Kristalls und die Abhängigkeit der Energieniveaus von Magnetfeldstärke, Temperatur und Druck,
- Fig. 2a,b: schematische Darstellungen einer Magnetresonanz, die mit Hilfe eines frequenzmodulierten Mikrowellensignals angeregt wird, sowie eines Magnetresonanz-Signals, das mittels eines Lock-In-Verstärkers demoduliert wurde,
- Fig. 3: eine schematische Darstellung eines Ausführungsbeispiels eines Magnetfeldgradiometers mit zwei Frequenzmischern zur Bildung jeweils eines Mikrowellensignals mit zwei um π zueinander phasenversetzten Frequenzanteilen, die über einen jeweiligen Mikrowellenemitter in abgestrahlt werden, um einen ersten und zweiten Messbereich mit einem Mikrowellenfeld zu beaufschlagen,
- Fig. 4: eine schematische Darstellung der Frequenzanteile eines Mikrowellensignals des Magnetfeldgradiometers von Fig. 3,
- Fig. 5: schematische Darstellungen von demodulierten Einzel- und Doppelresonanz-Signalen sowie deren Abhängigkeit von Resonanzabweichungen, die auf Änderungen des Magnetfelds und der Temperatur zurückzuführen sind,
- Fig. 6: eine schematische Darstellung eines Ausführungsbeispiels eines Magnetfeldgradiometers mit zwei Leistungsaddieren zur Addition von jeweils zwei frequenzmodulierten Mikrowellensignalen zu einem ersten bzw. zweiten Mikrowellensignal,
- Fig. 7: eine schematische Darstellung der Frequenzanteile eines Mikrowellensignals des Magnetfeldgradiometers von Fig. 6, sowie
- Fig. 8: eine schematische Darstellung eines Ausführungsbeispiels eines Magnetfeldgradiometers, das für die Auswertung des Fluoreszenzlichts aus dem ersten und dem zweiten Messbereich jeweils ein Paar von Demodulatoren aufweist.

In der folgenden Beschreibung der Zeichnung werden für gleiche bzw. entsprechende Bauteile identische Bezugszeichen verwendet.

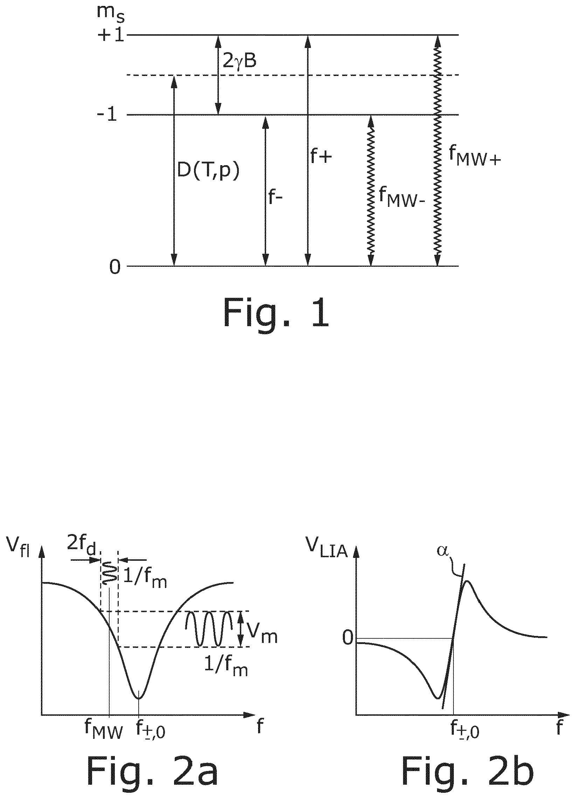

Fig. 1 zeigt ein Energieniveau-Schema eines Grundzustands eines NV-Zentrums eines Diamant-Kristalls, das in Form eines Tripletts vorliegt. Die drei Zustände des Tripletts unterscheiden sich in ihrer magnetischen Spinquantenzahl, *m*_{S} = -1,0, + 1. Die *m*_{S} =± 1 Zustände sind aufgrund der Spin-Spin-Wechselwirkung höherenergetisch als der *m*_{S} = 0 Zustand. Ohne Magnetfeld sind die *m*_{S} =± 1 Zustände entartet (bei Vernachlässigung der Hyperfeinstruktur), haben also die gleiche Energie. In Gegenwart eines Magnetfelds ist aufgrund des Zeeman-Effekts die Entartung der *m*_{S} =± 1 Zustände proportional zum Magnetfeld aufgehoben. Es existieren daher zwei Resonanzfrequenzen *f₊* und *f₋*, entsprechend den Übergängen zwischen dem *m*_{S} = 0 und dem *m*_{S} = +1 Zustand bzw. dem *m*_{S} = -1 Zustand.

Die Resonanzfrequenzen *f*_{±} sind abhängig vom Magnetfeld B, der Temperatur T und dem Druck p am Ort des jeweiligen NV-Zentrums. Es gilt (vgl. Fig. 1): ${f}_{\pm } = D \left(T, p\right) \pm γB .$ *γ* bezeichnet hierbei das gyromagnetische Verhältnis der NV-Zentren und B die Projektion des Magnetfelds auf die entsprechende Achse des NV-Zentrums.

Wie sich aus obiger Formel ergibt, können Schwankungen der Temperatur *T* und des Drucks p von Magnetfeldänderungen separiert werden, wenn beide Resonanzfrequenzen *f*_{±} bekannt sind: ${f}_{+} - {f}_{-} = 2 γB .$

Wie in Fig. 1 ebenfalls zu erkennen ist, können zur Anregung der beiden Resonanzfrequenzen *f*_{±} zwei Mikrowellenfelder mit entsprechenden Mikrowellenfrequenzen *f_{MW+}, f_{MW-}* verwendet werden.

Durch Einstrahlung von Anregungslicht im grünen Wellenlängenbereich können die NV-Zentren aus dem in Fig. 1 gezeigten Grundzustand in den angeregten Zustand gepumpt werden, der ebenfalls in Form eines Tripletts vorliegt. Die Rückkehr in den Grundzustand erfolgt teilweise unter Emission von rotem Fluoreszenzlicht. Die Intensität dieses Fluoreszenzlichts hängt von der Populationsverteilung zwischen den *m*_{S} = -1,0, + 1 Zuständen des Triplett-Grundzustands ab. Durch Wechselwirkung mit einem resonanten Mikrowellenfeld kann diese Populationsverteilung beeinflusst werden. Genauer gesagt kommt es bei einem Mikrowellenfeld mit den Frequenzen *f_{MW+}* und *f_{MW-}*, entsprechend den Frequenzen *f*_{±,0} der Übergänge zwischen dem *m*_{S} = 0 und dem *m*_{S} = +1 Zustand bzw. dem *m*_{S} = -1 Zustand, zu einem Abfall der detektierten Intensität des Fluoreszenzlichts *v_{FL}*, wie dies in Fig. 2a zu erkennen ist, welches die Intensität *v_{FL}* des Fluoreszenzlichts in Abhängigkeit von der Frequenz f zeigt. Die Intensität *v_{FL}* des Fluoreszenzlichts weist bei der jeweiligen Resonanzfrequenz *f*_{±,0} ein Minimum auf.

Die Adressierung der Magnetresonanzen erfolgt mittels eines frequenzmodulierten Mikrowellenfeldes *f_{MW}*(*t*), welches folgene Form aufweist: ${f}_{MW} \left(t\right) = {f}_{MW} + {f}_{d} cos \left(2{πf}_{m}t\right) ,$ wobei *f_{MW}* die Trägerfrequenz, *f_{d}* die Modulationsamplitude und *fₘ* die Modulationsfrequenz bezeichnen. Die Intensität *v_{FL}* des Fluoreszenzlichts wird entsprechend mit einer Modulationsamplitude *Vₘ* und mit der Modulationsfrequenz *fₘ* moduliert.

Fig. 2b zeigt das mittels eines Demodulators in Form eines Lock-In-Verstärkers aus dem detektierten Fluoreszenzlicht erzeugte Signal *v_{LIA}* in Abhängigkeit von der Frequenz f. Wie in Fig. 2b zu erkennen ist, weist das demodulierte Signal *v_{LIA}* eine dispersive Form auf und ist um die jeweilige Resonanzfrequenz *f*_{±,0} linear. Aus dem demodulierten Signal *v_{LIA}* kann die Steigung α des linearen Bereichs bestimmt werden. Verändert sich die Resonanzfrequenz aufgrund von Magnetfeld-, Temperatur- und/oder Druckänderungen, so kann die Resonanzabweichung (Verstimmung) Δ von der Resonanzfrequenz *f*_{±,0} anhand des demodulierten Signals *v_{LIA}* ausgewertet werden. Es gilt: Δ = *v_{LIA}* / α.

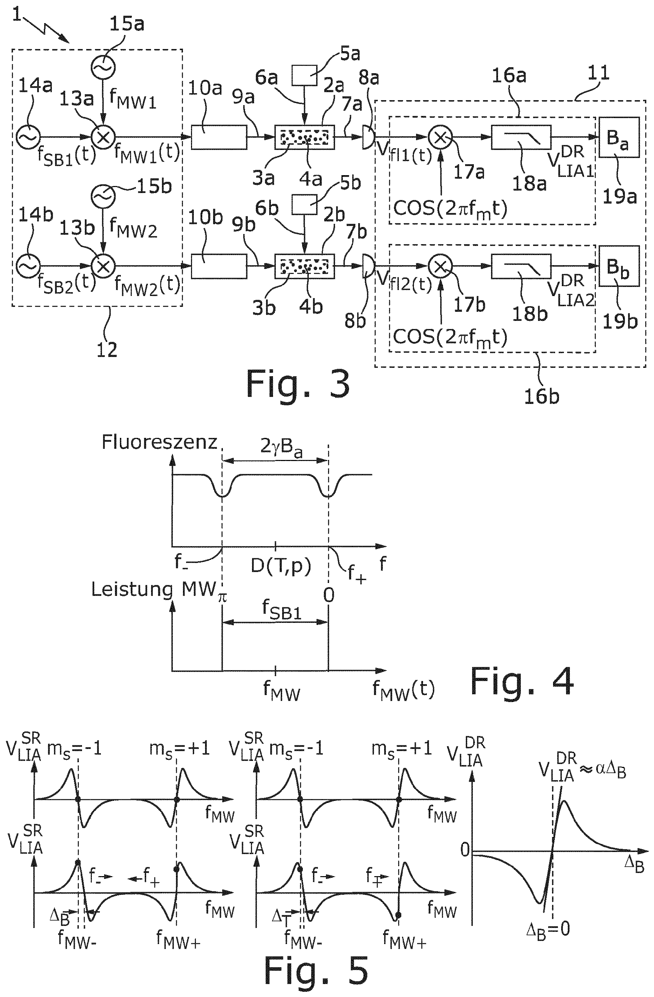

Das weiter oben beschriebene Messprinzip kann zur simultanen Anregung beider Magnetfeldresonanzen eines NV-Zentrums verwendet werden. Nachfolgend wird in Zusammenhang mit Fig. 3 ein Magnetfeldgradiometer 1 beschrieben, bei dem dies der Fall ist.

Das Magnetfeldgradiometer 1 umfasst einen ersten Diamant-Kristall 2a und einen zweiten Diamant-Kristall 2b, die jeweils einen Messbereich 3a, 3b aufweisen, in dem der Diamant-Kristall 2a, 2b mit NV-Zentren 4a, 4b dotiert ist. Das Magnetfeldgradiometer 1 umfasst auch zwei Anregungslichtquellen 5a, 5b, die jeweils zur Emission von Anregungslicht 6a, 6b im grünen Wellenlängenbereich dienen. Bei der Anregung der NV-Zentren 4a, 4b in dem jeweiligen Messbereich 3a, 3b wird Fluoreszenzlicht 7a, 7b im roten Wellenlängenbereich erzeugt, das von einem jeweiligen Detektor 8a, 8b in Form einer Fotodiode detektiert wird.

Zur Bestimmung der Stärke des Magnetfelds Bₐ, B_{b} in dem jeweiligen Messbereich 3a, 3b wird der jeweilige Diamant-Kristall 2a, 2b zusätzlich zur Bestrahlung mit dem Anregungslicht 6a, 6b mit einem jeweiligen Mikrowellenfeld 9a, 9b beaufschlagt, das von einem zugehörigen Mikrowellenemitter 10a, 10b erzeugt wird. Für die Bestimmung der Stärke des jeweiligen Magnetfeldes Bₐ, B_{b} weist das Magnetfeldgradiometer 1 eine Auswerteeinrichtung 11 auf. Ein Signalerzeuger 12 dient zur Erzeugung eines ersten Mikrowellensignals f_{MW1}(t) für den ersten Mikrowellenemitter 10a und eines zweiten Mikrowellensignals f_{MW2}(t) für den zweiten Mikrowellenemitter 10b.

Zur Bildung des ersten Mikrowellensignals f_{MW1}(t) weist der Signalerzeuger 12 einen ersten Frequenzmischer 13a auf, der zur Frequenzmischung eines ersten frequenzmodulierten Signals f_{SB1}(t) und eines ersten Oszillatorsignals f_{MW1} ausgebildet ist. Für die Erzeugung des ersten frequenzmodulierten Signals f_{SB1}(t) weist der Signalerzeuger 12 einen ersten Signalgenerator 14a auf. Zur Erzeugung des ersten Oszillatorsignals f_{MW1} weist der Signalerzeuger 12 einen ersten Oszillator 15a auf.

Zur Bildung des zweiten Mikrowellensignals f_{MW2}(t) weist der Signalerzeuger 12 einen zweiten Frequenzmischer 13b auf, der zur Frequenzmischung eines zweiten frequenzmodulierten Signals f_{SB2}(t) und eines zweiten Oszillatorsignals f_{MW2} ausgebildet ist. Für die Erzeugung des zweiten frequenzmodulierten Signals f_{SB2}(t) weist der Signalerzeuger 12 einen zweiten Signalgenerator 14b auf. Zur Erzeugung des zweiten Oszillatorsignals f_{MW2} weist der Signalerzeuger 12 zudem einen zweiten Oszillator 15b auf.

Der erste Signalgenerator 14a ist ausgebildet, das erste frequenzmodulierte Signal *f_{SB1}(t)* mit einer Trägerfrequenz *f*_{*SB*1}, einer Modulationsfrequenz *f*_{*m*1} und einer Modulationsamplitude *f*_{*d*1} in nachfolgend angegebener Form zu erzeugen: ${f}_{SB 1} \left(t\right) = {f}_{SB 1} + {f}_{d 1} cos \left(2{πf}_{m 1}t\right) .$

Entsprechend ist der zweite Signalgenerator 14b ausgebildet, das zweite frequenzmodulierte Signal *f_{SB2}(t)* mit einer Trägerfrequenz *f*_{*SB*2}, einer Modulationsfrequenz *f*_{*m*2} und einer Modulationsamplitude *f*_{*d*2} in nachfolgender Form zu erzeugen: ${f}_{SB 2} \left(t\right) = {f}_{SB 2} + {f}_{d 2} cos \left(2{πf}_{m 2}t\right) .$

Der erste Oszillator 15a erzeugt das erste Oszillatorsignal *f*_{*MW*1} mit einer konstanten ersten Oszillationsfrequenz, die zur Vereinfachung mit *f*_{*MW*1} bezeichnet wird. Entsprechend erzeugt der zweite Oszillator 15b das zweite Oszillatorsignal *f*_{*MW*2} mit einer konstanten zweiten Oszillationsfrequenz, die zur Vereinfachung mit *f*_{*MW*2} bezeichnet wird.

Wie weiter oben beschrieben wurde, dient der erste Frequenzmischer 13a zur Bildung des ersten Mikrowellensignals *f_{MW1}(t)* durch Frequenzmischung des ersten frequenzmodulierten Signals *f_{SB1}(t)* und des ersten Oszillatorsignals *f_{MW1}.* Das erste Mikrowellensignal *f_{MW1}(t)* weist nach der Frequenzmischung in dem ersten Frequenzmischer 13a folgende Frequenzanteile auf: ${f}_{MW 1} + {f}_{SB 1} + {f}_{d 1} cos \left(2{πf}_{m 1}t\right) und {f}_{MW 1} - {f}_{SB 1} + {f}_{d 1} cos \left(2{πf}_{m 1}t+π\right)$

Durch die Frequenzmischung ergibt sich somit ein Phasenunterschied von π bzw. von 180° zwischen den beiden Frequenzanteilen *f*_{*d*1}cos(2*πf*_{*m*1}*t*) und *f*_{*d*1} cos(2*πf*ₘ₁*t* + *π*) des ersten Mikrowellensignals *f_{MW1}(t).*

Das oben Gesagte gilt entsprechend für das zweite Mikrowellensignal *f_{MW2}(t),* das von dem zweiten Frequenzmischer 13b durch Frequenzmischung des zweiten frequenzmodulierten Signals *f_{SB2}(t)* und des zweiten Oszillatorsignals *f_{MW2}* erzeugt wird. Das zweite Mikrowellensignal *f_{MW2}(t)* weist daher ebenfalls zwei Frequenzanteile *f*_{*d*2}cos(2*πf*_{*m*2}*t*) und *f*_{*d*2}cos(2*πf*_{*m*2}*t* + *π*) auf, die einen Phasenunterschied von π bzw. von 180° zueinander aufweisen.

Die Trägerfrequenz *f*_{*SB*1} des ersten frequenzmodulierten Signals *f_{SB1}(t)* und die Oszillatorfrequenz *f*_{*MW*1} des ersten Oszillatorsignals *f*_{*MW*1} werden so gewählt, dass bei einer gegebenen Feldstärke des Magnetfeldes Bₐ in dem ersten Messbereich 3a die beiden um π phasenverschobenen Frequenzanteile den beiden Resonanzfrequenzen *f₊, f*₋ der Übergänge zwischen dem *m*_{S} = 0 und dem *m*_{S} = +1 Zustand bzw. dem *m*_{S} = -1 Zustand entsprechen, wie dies in **Fig.** 4 veranschaulicht ist. Entsprechend wird die Trägerfrequenz *f*_{*SB*2} des zweiten frequenzmodulierten Signals *f_{SB2}(t)* und die Oszillatorfrequenz *f*_{*MW*2} des zweiten Oszillatorsignals *f*_{*MW*2} so gewählt, dass die beiden Resonanzfrequenzen *f₊, f*₋ der Übergänge zwischen dem *m*_{S} = 0 und dem *m*_{S} = +1 Zustand beziehungsweise dem *m*_{S} = -1 Zustand der NV-Zentren 4b in dem zweiten Messbereich 3b adressiert werden.

Bei dem Magnetfeldgradiometer 1 von Fig. 3 soll das Magnetfeld Bₐ in dem ersten Messbereich 3a gemessen werden. Das Magnetfeld B_{b} am Ort des zweiten Messbereichs 3b wird zur Messung des Umgebungsmagnetfeldes verwendet. Durch die Bildung des Magnetfeldgradienten Bₐ - B_{b}, d.h. der Differenz zwischen dem ersten Magnetfeld Bₐ in dem ersten Messbereich 3a und dem zweiten Magnetfeld B_{b} in dem zweiten Messbereich 3b kann das Rauschen des Umgebungsmagnetfeldes unterdrückt werden. Aufgrund der unterschiedlichen Feldstärken der Magnetfelder Bₐ, B_{b} in dem jeweiligen Messbereich 3a, 3b ist es typischerweise erforderlich, dass das erste und das zweite frequenzmodulierte Signal *f_{SB1}(t), f_{SB2}(t)* unterschiedliche Trägerfrequenzen *f_{SB1}, f_{SB2}* aufweisen bzw. dass das erste Oszillatorsignal *f_{MW1}* und das zweite Oszillatorsignal *f_{MW2}* unterschiedliche Oszillationsfrequenzen *f_{MW1}, f_{MW2}* aufweisen.

Wie in Fig. 2 zu erkennen ist, weist die Auswerteeinrichtung 11 einen ersten Demodulator 16a zur Bildung eines ersten demodulierten Doppelresonanz-Signals *v_{LIA1}^{DR}* **aus** dem mittels des ersten Detektors 8a detektierten Fluoreszenzlicht bzw. eines entsprechenden Fluoreszenzsignals *v_{FL1}(t)* des ersten Messbereichs 3a auf. Entsprechend weist die Auswerteeinrichtung 11 auch einen zweiten Demodulator 16b zur Bildung eines zweiten demodulierten Doppelresonanz-Signals *v_{LIA2}^{DR}* aus dem mittels des zweiten Detektors 8b detektierten Fluoreszenzlicht bzw. des entsprechenden Fluoreszenzsignals *v_{FL2}(t)* aus dem zweiten Messbereich 3b auf. Die beiden Demodulatoren 16a, 16b sind als Lock-In-Verstärker ausgebildet und weisen jeweils einen Frequenzmischer 17a, 17b und einen Tiefpassfilter 18a, 18b auf. Dem ersten Frequenzmischer 17a wird ein Referenzsignal zugeführt, das dem Frequenzanteil *f*_{*d*1}cos(2*πf*_{*m*1}*t*) des ersten Mikrowellensignals *f_{MW1}(t)* entspricht. Entsprechend wird dem zweiten Frequenzmischer 17b ein Referenzsignal zugeführt, das dem Frequenzanteil *f*_{*d*2}cos(2*πf*_{*m*2}*t*) des zweiten Mikrowellensignals *f_{MW2}(t)* entspricht. Das jeweilige erste bzw. zweite Doppelresonanz-Signal *v_{LIA1}^{DR}* bzw. *v_{LIA2}^{DR}* weist die aus Fig. 2b bekannte dispersive Form auf.

**Fig. 5** dient zur Veranschaulichung des Einflusses von Änderungen des Magnetfeldes, der Temperatur und des Drucks auf ein in Fig. 5 rechts dargestelltes demoduliertes Doppelresonanz-Signal *v_{LIA}^{DR},* bei dem es sich beispielsweise um das erste oder das zweite demodulierte Doppelresonanz-Signal *v_{LIA1}^{DR}* bzw. *v_{LIA2}^{DR}* von Fig. 3 handeln kann. Um den Einfluss der Änderung der obengenannten Größen auf das demodulierte Doppelresonanz-Signal *v_{LIA}^{DR}* zu verstehen, sind in Fig. 5 links und in der Mitte die jeweiligen demodulierten Einzelresonanz-Signale *v_{LIA}^{SR}* dargestellt. Aufgrund der relativen Modulationsphase von π bzw. 180° zwischen den beiden Frequenzanteilen des Mikrowellenfeldes resultiert eine vertikale Spiegelung der Einzelresonanz-Signale *v_{LIA}^{SR}* der beiden Magnetresonanzen des *m*_{S} = +1 Zustands beziehungsweise des *m*_{S} = -1 Zustands.

Wie in Fig. 5 links unten zu erkennen ist, führt eine auf eine Änderung des Magnetfels zurückzuführende Resonanzverschiebung Δ_{B} zu einer Verschiebung der Einzelresonanz-Signale *v_{LIA}^{SR},* die eine konstruktive Addition im Doppelresonanz-Signal bewirkt (vgl. die Punkte in Fig. 5 links unten). Auf eine Änderung der Temperatur oder des Drucks zurückzuführende Resonanzverschiebungen Δ_{T} (bzw. Δₚ, nicht gezeigt) führen hingegen zu einer destruktiven Addition der Einzelresonanz-Signale *v_{LIA}^{SR}* (vgl. die Punkte in Fig. 5 in der Mitte unten) Wie in Fig. 5 rechts dargestellt ist, hängt daher das demodulierte Doppelresonanz-Signal *v_{LIA}^{DR}* nur von der magntefeldbedingten Resonanzabweichung Δ_{B} des jeweiligen Magnetfelds Bₐ, B_{b} in dem ersten Messbereich 3a bzw. in dem zweiten Messbereich 3b ab. Wie in Fig. 5 rechts zu erkennen ist, ist das demodulierte Doppelresonanz-Signal *v_{LIA}^{DR}* im Bereich der Magnetresonanz um Δ_{B} linear. Entsprechend kann anhand des demodulierten Doppelresonanzsignals *v_{LIA}^{DR}* die magnetfeldabhängige Resonanzabweichung Δ*_{B}* unter Berücksichtigung der Steigung α wie folgt bestimmt werden: ${Δ}_{B} = {V}_{LIA}^{DR} / α$*.*

Die obigen Betrachtungen gelten sowohl für das erste demodulierte Doppelresonanz-Signal *v_{LIA1}^{DR}* als auch für das zweite demodulierte Doppelresonanz-Signal *v_{LIA2}^{DR}* des in Fig. 3 dargestellten Magnetfeldgradiometers 1. Die nachfolgenden Betrachtungen beziehen sich auf das erste Doppelresonanz-Signal *v_{LIA1}^{DR}* und gelten für das zweite Doppelresonanz-Signal *v_{LIA2}^{DR}* entsprechend.

Für die Bestimmung des ersten Magnetfelds Bₐ in der Auswerteeinrichtung 11 wird wie folgt vorgegangen: In einem Kalibrierungsschritt wird ein Einzelresonanz-Spektrum der beiden Magnetresonanzen (vgl. Fig. 2a bzw. Fig. 4) aufgenommen, um die Resonanzfrequenzen *f*_{+,0} und *f*_{*-*,0} zum Zeitpunkt der Kalibrierung zu bestimmen. In einem nachfolgenden Schritt wird bei der Kalibrierung auf die weiter oben beschriebene Weise das erste demodulierte Doppelresonanz-Signal *v_{LIA1}^{DR}* aufgenommen und der skalare Faktor α bzw. die Steigung bei Δ_{B} = 0 wird bestimmt. Nachfolgend werden die Trägerfrequenz *f*_{*SB*1} des ersten frequenzmodulierten Signals *f_{SB1}(t)* und die Oszillatorfrequenz *f*_{*MW*1} des ersten Oszillatorsignals *f*_{*MW*1} so gewählt bzw. fest eingestellt, dass für die bei der Kalibrierung vorliegende Feldstärke des Magnetfeldes Bₐ in dem ersten Messbereich 3a die beiden um π phasenverschobenen Frequenzanteile den beiden Resonanzfrequenzen *f*_{*+,*0}, *f*_{*-*,0} der Übergänge zwischen dem *m*_{S} = 0 und dem *m*_{S} = +1 Zustand bzw. dem *m*_{S} = -1 Zustand entsprechen (vgl. auch Fig. 4).

Nach der Kalibrierung erfolgt eine kontinuierliche Bestimmung des ersten Magnetfeldes Bₐ über folgende Gleichung: $2 {γB}_{a} = {f}_{+ , 0} - {f}_{- , 0} + 2 {V}_{LIA 1}^{DR} / α$

Die Bestimmung des zweiten Magnetfelds B_{b} erfolgt analog. Für die Berechnung des jeweiligen Magnetfeldes Bₐ, B_{b} aus dem ersten bzw. aus dem zweiten demodulierten Doppelresonanz-Signal *v_{LIA1}^{DR}* bzw. *v_{LIA2}^{DR}* weist die Auswerteeinrichtung 11 eine jeweilige Rechenlogik 19a, 19b auf, die in Form eine geeigneten Hard- und/oder Software ausgebildet ist.

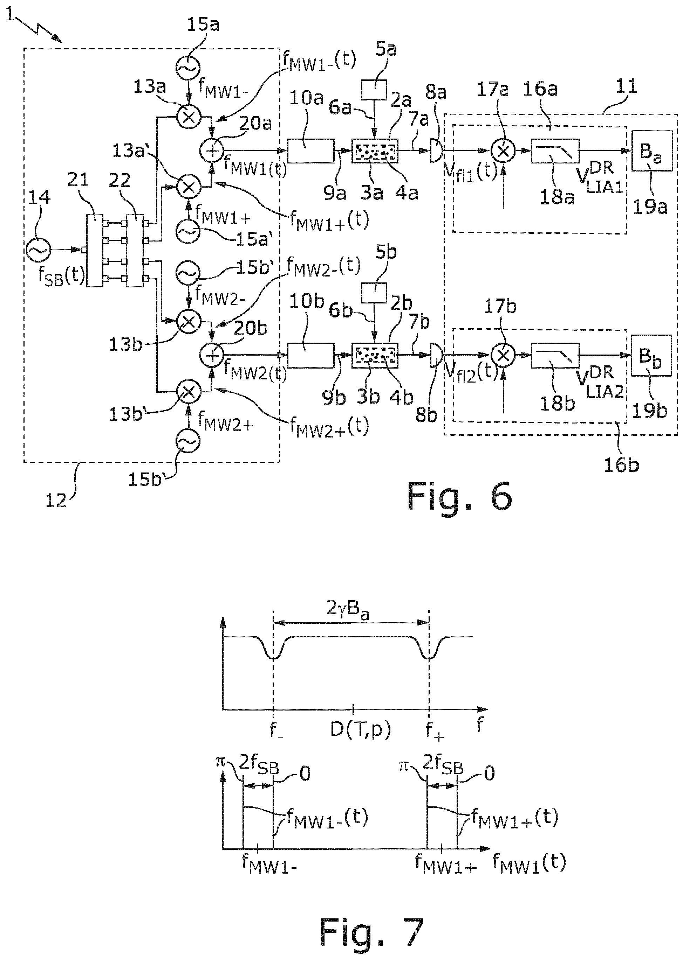

**Fig.** 6 zeigt ein Magnetfeldgradiometer 1, das auf demselben Messprinzip wie das in Fig. 3 gezeigte Magnetfeldgradiometer 1 beruht. Das in Fig. 6 gezeigte Magnetfeldgradiometer 1 unterscheidet sich von dem in Fig. 3 gezeigten Magnetfeldgradiometer im Wesentlichen durch den Aufbau des Signalerzeugers 12, der dazu dient, die Leistung der Frequenzbänder, welche die jeweiligen Magnetresonanzen adressieren, individuell einzustellen. Der Signalerzeuger 12 weist zur Bildung des ersten Mikrowellensignals f_{MW1}(t) einen ersten Leistungsaddierer 20a zum Addieren eines ersten frequenzmodulierten Mikrowellensignals f_{MW1-}(t) mit zwei um π zueinander phasenversetzten Frequenzanteilen und eines weiteren ersten frequenzmodulierten Mikrowellensignals f_{MW1+}(t) mit zwei um π zueinander phasenversetzten Frequenzanteilen auf. Zusätzlich weist der Signalerzeuger 12 zur Bildung des zweiten frequenzmodulierten Mikrowellensignals f_{MW2}(t) einen zweiten Leistungsaddierer 20b zum Addieren eines zweiten frequenzmodulierten Mikrowellensignals f_{MW2-}(t) mit zwei um π zueinander phasenversetzten Frequenzanteilen und eines weiteren zweiten frequenzmodulierten Mikrowellensignals f_{MW2+}(t) mit zwei um π zueinander phasenversetzten Frequenzanteilen auf.

Der Signalerzeuger 12 weist zur Bildung des ersten frequenzmodulierten Mikrowellensignals f_{MW1-}(t) einen ersten Frequenzmischer 13a zur Frequenzmischung eines frequenzmodulierten Signals f_{SB}(t) und eines ersten Oszillatorsignals f_{MW1-} auf. Entsprechend weist der Signalerzeuger 12 zur Bildung des weiteren ersten frequenzmodulierten Mikrowellensignals f_{MW1+}(t) einen weiteren ersten Frequenzmischer 13a' zur Frequenzmischung des frequenzmodulierten Signals f_{SB}(t) und eines weiteren ersten Oszillatorsignals f_{MW1+} auf.

Der Signalerzeuger 12 umfasst zur Bildung des zweiten frequenzmodulierten Mikrowellensignals f_{MW2-}(t) zudem einen zweiten Frequenzmischer 13b zur Frequenzmischung des frequenzmodulierten Signals f_{SB}(t) und eines zweiten Oszillatorsignals f_{MW1-}. Der Signalerzeuger 12 umfasst weiterhin zur Bildung des weiteren zweiten frequenzmodulierten Mikrowellensignals f_{MW2+}(t) einen weiteren zweiten Frequenzmischer 13b', der zur Frequenzmischung des frequenzmodulierten Signals f_{SB}(t) und eines weiteren zweiten Oszillatorsignals f_{MW2+} dient.

Das frequenzmodulierte Signal f_{SB}(t) wird in einem Signalgenerator 14 des Signalerzeugers 12 erzeugt. Das erste Oszillatorsignal f_{MW1-} und das weitere erste Oszillatorsignal f_{MW1+} werden in einem ersten Oszillator 15a bzw. in einem weiteren ersten Oszillator 15a' erzeugt. Entsprechend werden das zweite Oszillatorsignal f_{MW2-}und das weitere zweite Oszillatorsignal f_{MW2+} in einem zweiten Oszillator 15b bzw. in einem weiteren zweiten Oszillator 15b' erzeugt.

Der Signalerzeuger 12 ist ausgebildet, die Leistung des ersten frequenzmodulierten Mikrowellensignals f_{MW1-}(t) und des weiteren ersten frequenzmodulierten Mikrowellensignals f_{MW1+}(t) unabhängig voneinander einzustellen. Der Signalerzeuger 12 ist zudem ausgebildet, die Leistung des zweiten frequenzmodulierten Mikrowellensignals f_{MW2-}(t) und des weiteren zweiten frequenzmodulierten Mikrowellensignals f_{MW2+}(t) unabhängig voneinander einzustellen.

Zu diesem Zweck wird die Leistung des frequenzmodulierten Signals f_{SB}(t) zunächst an einem Leistungsteiler 21 auf vier gleich große Leistungsanteile aufgeteilt. Nachfolgend wird mit Hilfe eines programmierbaren Abschwächers 22 der Leistungsanteil des frequenzmodulierten Signals f_{SB}(t), der einem jeweiligen Frequenzmischer 13a, 13a', 13b, 13b' zugeführt wird, individuell eingestellt.

Alternativ oder zusätzlich ist es möglich, dass die vier Oszillatoren 15a, 15a', 15b, 15b'ausgebildet sind, das entsprechende Oszillatorsignal f_{MW1-}, f_{MW1+}, f_{MW2-}, f_{MW2+} mit jeweils individuell einstellbarer Leistung zu erzeugen.

Fig. 7 zeigt analog zur Darstellung von Fig. 4 die Frequenzanteile des ersten Mikrowellensignals f_{MW1}(t), das von dem Signalgenerator 12 von Fig. 6 erzeugt wird. Wie in Fig. 7 zu erkennen ist, weist das erste Mikrowellensignal f_{MW1}(t) zwei Paare mit jeweils zwei um π zueinander phasenverschobenen Frequenzanteilen auf. Durch die Möglichkeit, die Leistung für die jeweiligen Frequenzbänder bzw. für das erste frequenzmodulierte Mikrowellensignal f_{MW1-}(t) und für das zweite frequenzmodulierte Mikrowellensignal f_{MW1+}(t) individuell einzustellen, kann der Unterschied der Skalar-Faktoren α der jeweiligen Einzelresonanz-Spektren minimiert werden und somit die Unterdrückung von Temperatur- und Druckänderungen im Doppelresonanz-Signal *v_{LIA1}^{PR}* maximiert werden. Es versteht sich, dass die obigen Betrachtungen analog auch für das zweite Mikrowellensignal *f_{MW2}(t)* gelten.

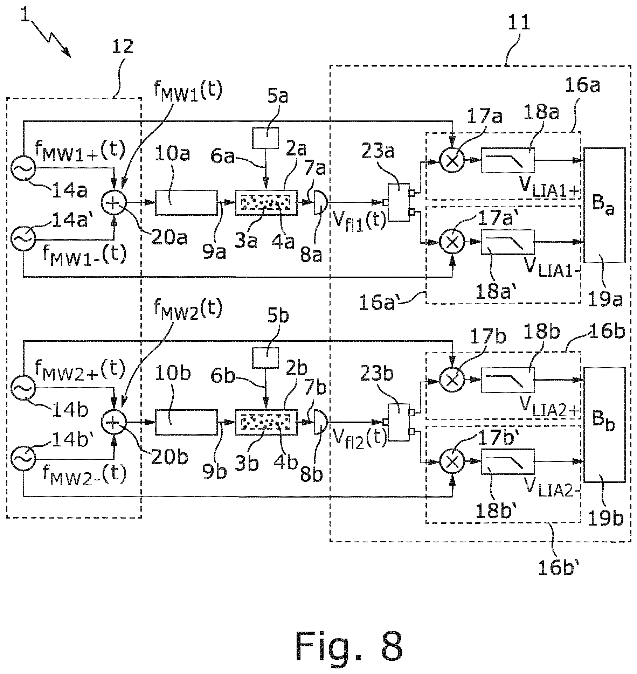

Fig. 8 zeigt ein Magnetfeldgradiometer 1, das sich von den in Fig. 3 und Fig. 6 gezeigten Magnetfeldgradiometern durch den Aufbau des Signalerzeugers 12 und der Auswerteeinrichtung 11 unterscheidet. Der Signalerzeuger 12 weist bei dem in Fig. 8 gezeigten Magnetfeldgradiometer 1 einen ersten Leistungsaddierer 20a zur Bildung eines ersten Mikrowellensignals f_{MW1}(t) für den ersten Mikrowellenemitter 10a durch Addition von zwei ersten frequenzmodulierten Mikrowellensignalen f_{MW1+}(t), f_{MW1-}(t) auf. Entsprechend weist der Signalerzeuger 12 einen zweiten Leistungsaddierer 20b zur Bildung eines zweiten Mikrowellensignals f_{MW2}(t) für den zweiten Mikrowellenemitter 10b durch Addition von zwei zweiten frequenzmodulierten Mikrowellensignalen f_{MW2+}(t), f_{MW2-}(t) auf. Die ersten frequenzmodulierten Mikrowellensignale f_{MW1+}(t), f_{MW1-}(t) werden in einem jeweiligen ersten bzw. weiteren ersten Signalgenerator 14a, 14a' erzeugt. Entsprechend werden die zweiten frequenzmodulierten Mikrowellensignale f_{MW2+}(t), f_{MW2-}(t) in einem jeweiligen zweiten bzw. einem weiteren zweiten Signalgenerator 14b, 14b' erzeugt.

Für die ersten frequenzmodulierten Mikrowellensignale f_{MW1+}(t), f_{MW1-}(t) gilt: ${f}_{MW 1 \pm } \left(t\right) = {f}_{MW 1 \pm } + {f}_{d} cos \left(2{πf}_{m 1 \pm }t\right) ,$ wobei *f*_{MW1±} die jeweilige Trägerfrequenz, *f*_{*m*1±} die jeweilige Modulationsfrequenz und *f_{d}* die Modulationsamplitude bezeichnen. Die Trägerfrequenzen *f*_{*m*1±} der beiden ersten frequenzmodulierten Mikrowellensignale f_{MW1+}(t), f_{MW1-}(t) unterscheiden sich voneinander, um jeweils eine der beiden Magnetresonanzen der NV-Zentren 4a in dem ersten Messbereich 3a anzuregen.

Das Fluoreszenzsignal *V*_{*fl*1}(*t*), welches von dem ersten Detektor 8a des Magnetfeldgradiometers 1 detektiert wird, umfasst daher Informationen über die Magnetresonanzen in zwei unterschiedlichen Frequenzbändern, welche um *f*_{*m*1±} zentriert sind. Die Auswerteeinrichtung 11 umfasst einen ersten Leistungsteiler 23a zur Aufteilung der Leistung des detektierten Fluoreszenzsignals *V*_{*fl*1}(*t*) aus dem ersten Messbereich 3a auf ein erstes Paar von Demodulatoren 16a, 16a'. Entsprechend dient ein zweiter Leistungsteiler 23b zur Aufteilung der Leistung des detektierten Fluoreszenzsignals *V*_{*fl*2}(*t*) aus dem zweiten Messbereich 3b auf ein zweites Paar von Demodulatoren 16b, 16b'. In einem jeweiligen Demodulator 16a, 16a', 16b, 16b' wird ein demoduliertes Einzelresonanz-Signal v_{LIA1+}, v_{LIA1-},v_{LIA2+}, v_{LIA2-}erzeugt, das auf die weiter oben in Zusammenhang mit Fig. 2b beschriebene Weise ausgewertet werden kann.

Für das erste Magnetfeld Bₐ in dem ersten Messbereich 3a ergibt sich folgende Beziehung: $2 {γB}_{a} = \left({f}_{+ , 0}+\frac{{V}_{LIA 1 +}}{{α}_{1 +}}\right) - \left({f}_{- , 0}+\frac{{V}_{LIA 1 -}}{{α}_{1 -}}\right) ,$ wobei *α*₁₊ und *α*₁₋ die Steigung des jeweiligen Einzelresonanz-Signals v_{LIA1+,} v_{LIA1-}bei Δ_{B} = 0 bezeichnen. Das erste Magnetfeld Bₐ wird in einer ersten Rechenlogik 19a mit Hilfe der oben angegebenen Formel aus den beiden demodulierten Einzelresonanz-Signalen v_{LIA1+}, v_{LIA1-} bestimmt. Entsprechendes gilt für die Bestimmung des zweiten Magnetfelds B_{b} in dem zweiten Messbereich 3b anhand der beiden zweiten demodulierten Einzelresonanz-Signale v_{LIA2+}, v_{LIA2-} in einer zweiten Rechenlogik 19b.

Zusammenfassend kann mit Hilfe der weiter oben beschriebenen Magnetfeldgradiometer 1 die Bestimmung des jeweiligen Magnetfelds Bₐ, B_{b} bzw. des Magnetfeldgradienten Bₐ - B_{B} entkoppelt von Temperatur- und Druckänderungen durchgeführt werden, ohne dass hierbei die Bandbreite des Magnetfeldgradiometers 1 limitiert wird. Somit ist der volle Dynamikumfang des Magnetfeldgradiometers1 nutzbar. Es ist in der Regel auch nicht erforderlich, die jeweiligen Diamant-Kristalle 3a, 3b zu erwärmen oder zu kühlen, um deren Temperatur zu stabilisieren.

## Patentansprüche

1. Magnetfeldgradiometer (1) zur Bestimmung eines Magnetfeldgradienten (Bₐ - B_{b}), umfassend:
mindestens eine Anregungslichtquelle (5a, 5b) zur Emission von Anregungslicht (6a, 6b),
zwei räumlich beabstandete Messbereiche (3a, 3b) zur Magnetfeld-Messung, die Farbzentren in einem Diamant, bevorzugt NV-Zentren (4a, 4b), aufweisen, die bei einer Anregung mit dem Anregungslicht (6a, 6b) Fluoreszenzlicht (7a, 7b) emittieren,
einen ersten Detektor (8a) zur Detektion des Fluoreszenzlichts (7a) aus dem ersten Messbereich (3a),
einen zweiten Detektor (8b) zur Detektion des Fluoreszenzlichts (7b) aus dem zweiten Messbereich (3b),
einen ersten Mikrowellenemitter (10a) zum Beaufschlagen des ersten Messbereichs (3a) mit einem ersten Mikrowellenfeld (9a),
einen zweiten Mikrowellenemitter (10b) zum Beaufschlagen des zweiten Messbereichs (3b) mit einem zweiten Mikrowellenfeld (9b),
sowie
eine Auswerteeinrichtung (11), die zur Bestimmung des Magnetfeldgradienten (Bₐ - B_{b}) anhand des detektierten Fluoreszenzlichts (7a) aus dem ersten Messbereich (3a) und anhand des detektierten Fluoreszenzlichts (7b) aus dem zweiten Messbereich (3b) ausgebildet ist,
**gekennzeichnet durch**
einen Signalerzeuger (12), der ausgebildet ist, ein erstes Mikrowellensignal (f_{MW1}(t)) für den ersten Mikrowellenemitter (10a) zu erzeugen, das mindestens zwei um π zueinander phasenversetzte Frequenzanteile aufweist, und ein zweites Mikrowellensignal (f_{MW2}(t)) für den zweiten Mikrowellenemitter (10b) zu erzeugen, das mindestens zwei um π zueinander phasenversetzte Frequenzanteile aufweist,
wobei der Signalerzeuger (12) zur Bildung des ersten Mikrowellensignals (f_{MW1}(t)) einen ersten Leistungsaddierer (20a), ausgebildet zum Addieren eines ersten
frequenzmodulierten Mikrowellensignals (f_{MW1-}(t)) mit zwei um π zueinander phasenversetzten Frequenzanteilen und eines weiteren ersten frequenzmodulierten Mikrowellensignals (f_{MW1+}(t)) mit zwei um π zueinander
phasenversetzten Frequenzanteilen, aufweist, und wobei der Signalerzeuger (12) zur Bildung des zweiten Mikrowellensignals (f_{MW2}(t)) einen zweiten Leistungsaddierer (20b), ausgebildet zum Addieren
eines zweiten frequenzmodulierten Mikrowellensignals (f_{MW2-}(t)) mit zwei um π zueinander phasenversetzten Frequenzanteilen und eines weiteren zweiten frequenzmodulierten Mikrowellensignals (f_{MW2+}(t)) mit zwei um π zueinander phasenversetzten Frequenzanteilen, aufweist.

2. Magnetfeldgradiometer nach Anspruch 1, bei dem der Signalerzeuger (12) ausgebildet ist, die Leistung des ersten frequenzmodulierten Mikrowellensignals (f_{MW1-}(t)) und des weiteren ersten frequenzmodulierten Mikrowellensignals (f_{MW1+}(t)) unabhängig voneinander einzustellen, und bei dem der Signalerzeuger (12) ausgebildet ist, die Leistung des zweiten frequenzmodulierten Mikrowellensignals (f_{MW2-}(t)) und des weiteren zweiten frequenzmodulierten Mikrowellensignals (f_{MW2+}(t)) unabhängig voneinander einzustellen.

3. Magnetfeldgradiometer nach einem der voranstehenden Ansprüche, bei dem der Signalerzeuger (12) zur Bildung des ersten frequenzmodulierten Mikrowellensignals (f_{MW1-}(t)) einen ersten Frequenzmischer (13a) zur Frequenzmischung eines frequenzmodulierten Signals (f_{SB}(t)) und eines ersten Oszillatorsignals (f_{MW1-}) und zur Bildung des weiteren ersten frequenzmodulierten Mikrowellensignals (f_{MW1+}(t)) einen weiteren ersten Frequenzmischer (13a') zur Frequenzmischung des frequenzmodulierten Signals (f_{SB}(t)) und eines weiteren ersten Oszillatorsignals (f_{MW1+}) aufweist.

4. Magnetfeldgradiometer nach Anspruch 3, bei dem der Signalgenerator (12) mindestens einen programmierbaren Abschwächer (22) zur einstellbaren Abschwächung eines jeweiligen Leistungsanteils des frequenzmodulierten Signals (f_{SB}(t)) aufweist, das einem jeweiligen Frequenzmischer (13a, 13a') zugeführt wird.

5. Magnetfeldgradiometer nach Anspruch 3 oder 4, bei dem der Signalerzeuger (12) einen ersten Oszillator (15a) zur Erzeugung des ersten Oszillatorsignals (f_{MW-}), bevorzugt mit einstellbarer Leistung, und einen weiteren ersten Oszillator (15a') zur Erzeugung des weiteren ersten Oszillatorsignals (f_{MW+}), bevorzugt mit einstellbarer Leistung, aufweist.

6. Magnetfeldgradiometer nach einem der vorhergehenden Ansprüche, bei dem die Auswerteeinrichtung (11) einen ersten Demodulator (16a) zur Bildung eines ersten demodulierten Doppelresonanz-Signals (v_{LIA1}^{DR}) aus dem detektierten Fluoreszenzlicht (v_{FL1}(t)) des ersten Messbereichs (3a) und einen zweiten Demodulator (16b) zur Bildung eines zweiten demodulierten Doppelresonanz-Signals (v_{LIA2}^{DR}) aus dem detektierten Fluoreszenzlicht (v_{FL2}(t)) des zweiten Messbereichs (3b) aufweist.

7. Magnetfeldgradiometer Anspruch 6, bei dem die beiden Demodulatoren (16a,b) als Lock-In-Verstärker ausgebildet sind.

8. Magnetfeldgradiometer nach Anspruch 6 oder 7, bei dem die Auswerteeinrichtung (11) ausgebildet ist, anhand des ersten demodulierten Doppelresonanz-Signals (v_{LIA1}^{DR}) eine magnetfeldabhängige Resonanzabweichung (Δ_{B}) eines ersten Magnetfelds (Bₐ) in dem ersten Messbereich (3a) zu bestimmen, und anhand des zweiten demodulierten Doppelresonanz-Signals (v_{LIA2}^{DR}) eine magnetfeldabhängige Resonanzabweichung (Δ_{B}) eines zweiten Magnetfelds (B_{b}) in dem zweiten Messbereich (3b) zu bestimmen.

9. Magnetfeldgradiometer nach dem Oberbegriff von Anspruch 1,
**dadurch gekennzeichnet,**
**dass** ein Signalerzeuger (12) einen ersten Leistungsaddierer (20a), ausgebildet zur Bildung
eines ersten Mikrowellensignals (f_{MW1}(t)) für den ersten Mikrowellenemitter (10a) durch Addition von zwei ersten frequenzmodulierten Mikrowellensignalen (f_{MW1+}(t), f_{MW1-}(t)) aufweist,
**dass** der Signalerzeuger (12) einen zweiten Leistungsaddierer (20b), ausgebildet zur Bildung
eines zweiten Mikrowellensignals (f_{MW2}(t)) für den zweiten Mikrowellenemitter (10b) durch Addition von zwei zweiten frequenzmodulierten Mikrowellensignalen (f_{MW2+}(t), f_{MW2-}(t)) aufweist, und
**dass** die Auswerteeinrichtung (11) einen ersten Leistungsteiler (23a) ausgebildet zur
Aufteilung der Leistung des detektierten Fluoreszenzlichts (v_{FL1}(t)) aus dem ersten Messbereich (3a) auf ein erstes Paar von Demodulatoren (16a, 16a') und einen zweiten Leistungsteiler (23b) ausgebildet zur Aufteilung der Leistung des detektierten
Fluoreszenzlichts (v_{FL2}(t)) aus dem zweiten Messbereich (3b) auf ein zweites Paar von Demodulatoren (16b, 16b') aufweist,
**dass** der Signalerzeuger (12) dazu ausgebildet ist, die ersten frequenzmodulierten Mikrowellensignale (f_{MW1+}(t), f_{MW1-}(t)) mit jeweils unterschiedlichen Trägerfrequenzen zu erzeugen und die zweiten frequenzmodulierten Mikrowellensignale (f_{MW2+}(t), f_{MW2-}(t)) mit jeweils unterschiedlichen Trägerfrequenzen zu erzeugen.

## Claims

1. Magnetic field gradiometer (1) for determining a magnetic field gradient (Bₐ - B_{b}), comprising:
at least one excitation light source (5a, 5b) for emitting excitation light (6a, 6b),
two spaced measurement regions (3a, 3b) for magnetic field measurement, which measurement regions have F centers in a diamond, preferably NV centers (4a, 4b) and which emit fluorescent light (7a, 7b) when excited by the excitation light (6a, 6b),
a first detector (8a) for detecting the fluorescent light (7a) from the first measurement region (3a),
a second detector (8b) for detecting the fluorescent light (7b) from the second measuring region (3b),
a first microwave emitter (10a) for applying a first microwave field (9a) to the first measurement range (3a), a second microwave emitter (10b) for applying a second microwave field (9b) to the second measurement range (3b),
and
an evaluation device (11) which is designed to determine the magnetic field gradient (Bₐ - B_{b}) based on the detected fluorescent light (7a) from the first measurement region (3a) and based on the detected fluorescent light (7b) from the second measurement region (3b),
**characterized by**
a signal generator (12) which is designed to generate a first microwave signal (f_{MW1}(t)) for the first microwave emitter (10a), which first microwave signal has at least two frequency components which are phase-shifted with respect to one another by π, and to generate a second microwave signal (f_{MW2}(t)) for the second microwave emitter (10b), which second microwave signal has at least two frequency components which are phase-shifted with respect to one another by π,
wherein, in order to form the first microwave signal (f_{MW1}(t)), the signal generator (12) has a first power adder (20a) designed to add a first frequency-modulated microwave signal (f_{MW1-}(t)) having two frequency components which are phase-shifted with respect to one another by π, and a further first frequency-modulated microwave signal (f_{MW1+}(t)) having two frequency components which are phase-shifted with respect to one another by π, and wherein, in order to form the second microwave signal (f_{MW2}(t)), the signal generator (12) has a second power adder (20b) designed to add a second frequency-modulated microwave signal (f_{MW2-}(t)) having two frequency components which are phase-shifted with respect to one another by π, and a further second frequency-modulated microwave signal (f_{MW2+}(t)) having two frequency components which are phase-shifted with respect to one another by π.

2. Magnetic field gradiometer according to claim 1, wherein the signal generator (12) is designed to adjust the power of the first frequency-modulated microwave signal (f_{MW1-}(t)) and of the further first frequency-modulated microwave signal (f_{MW1+}(t)) independently of one another, and wherein the signal generator (12) is designed to adjust the power of the second frequency-modulated microwave signal (f_{MW2-}(t)) and of the further second frequency-modulated microwave signal (f_{MW2+}(t)) independently of one another.

3. Magnetic field gradiometer according to any of the preceding claims, wherein, in order to form the first frequency-modulated microwave signal (f_{MW1-}(t)), the signal generator (12) has a first frequency mixer (13a) for frequency mixing of a frequency-modulated signal (f_{SB}(t)) and of a first oscillator signal (f_{MW1-}), and, in order to form the further first frequency-modulated microwave signal (f_{MW1+}(t)), the signal generator has a further first frequency mixer (13a') for frequency mixing of the frequency-modulated signal (f_{SB}(t)) and of a further first oscillator signal (f_{MW1+}).

4. Magnetic field gradiometer according to claim 3, wherein the signal generator (12) has at least one programmable attenuator (22) for adjustably attenuating a relevant power component of the frequency-modulated signal (f_{SB}(t)) which is fed to a relevant frequency mixer (13a, 13a').

5. Magnetic field gradiometer according to claim 3 or 4, wherein the signal generator (12) has a first oscillator (15a), preferably having adjustable power, for generating the first oscillator signal (f_{MW-}) and a further first oscillator (15a'), preferably having adjustable power, for generating the further first oscillator signal (f_{MW+}).

6. Magnetic field gradiometer according to any of the preceding claims, wherein the evaluation device (11) has a first demodulator (16a) for forming a first demodulated double resonance signal (v_{LIA1}^{DR}) from the detected fluorescent light (v_{FL1}(t)) of the first measurement region (3a), and a second demodulator (16b) for forming a second demodulated double resonance signal (v_{LIA2}^{DR}) from the detected fluorescent light (v_{FL2}(t)) of the second measurement region (3b).

7. Magnetic field gradiometer according to claim 6, wherein the two demodulators (16a,b) are designed as lock-in amplifiers.

8. Magnetic field gradiometer according to claim 6 or 7, wherein the evaluation device (11) is designed to determine, based on the first demodulated double resonance signal (v_{LIA1}^{DR}), a magnetic-field-dependent resonance deviation (Δ_{B}) of a first magnetic field (Bₐ) in the first measurement region (3a), and to determine, based on the second demodulated double resonance signal (v_{LIA2}^{DR}), a magnetic-field-dependent resonance deviation (Δ_{B}) of a second magnetic field (B_{b}) in the second measurement region (3b).

9. Magnetic field gradiometer according to the preamble of claim 1,
**characterized**
**in that** a signal generator (12) has a first power adder (20a), designed to form a first microwave signal (f_{MW1}(t)) for the first microwave emitter (10a) by adding two first frequency-modulated microwave signals (f_{MW1+}(t), (f_{MW1-}(t)),
**in that** the signal generator (12) has a second power adder (20b), designed to form a second microwave signal (f_{MW2}(t)) for the second microwave emitter (10b) by adding two second frequency-modulated microwave signals (f_{MW2+}(t), (f_{MW2-}(t)), and
**in that** the evaluation device (11) has a first power divider (23a) designed to divide the power of the detected fluorescent light (v_{FL1}(t)) from the first measurement region (3a) to a first pair of demodulators (16a, 16a') and a second power divider (23b) designed to divide the power of the detected fluorescent light (v_{FL2}(t)) from the second measurement region (3b) to a second pair of demodulators (16b, 16b') **in that** the signal generator (12) is designed to generate the first frequency-modulated microwave signals (f_{MW1+}(t), (f_{MW1-}(t)) having different carrier frequencies in each case and to generate the second frequency-modulated microwave signals (f_{MW2+}(t), (f_{MW2-}(t)) having different carrier frequencies in each case.

## Revendications

1. Gradiomètre de champ magnétique (1) pour la détermination d'un gradient de champ magnétique (Bₐ - B_{b}), comportant :
au moins une source de lumière d'excitation (5a, 5b) pour l'émission de lumière d'excitation (6a, 6b),
deux zones de mesure spatialement séparées (3a, 3b) pour la mesure du champ magnétique, présentant des centres de couleur dans un diamant, de préférence des centres NV (4a, 4b), qui, lorsqu'ils sont excités par la lumière d'excitation (6a, 6b), émettent de la fluorescence (7a, 7b),
un premier détecteur (8a) pour la détection de la lumière de fluorescence (7a) provenant de la première zone de mesure (3a),
un deuxième détecteur (8b) pour la détection de la lumière de fluorescence (7b) provenant de la deuxième zone de mesure (3b),
un premier émetteur micro-ondes (10a) pour exposer la première zone de mesure (3a) à un premier champ micro-ondes (9a),
un deuxième émetteur micro-ondes (10b) pour exposer la deuxième zone de mesure (3b) à un deuxième champ micro-ondes (9b), et
un dispositif d'évaluation (11), conçu pour déterminer le gradient de champ magnétique (Bₐ - B_{b}) à partir de la lumière de fluorescence détectée (7a) provenant de la première zone de mesure (3a) et à partir de la lumière de fluorescence détectée (7b) provenant de la deuxième zone de mesure (3b), **caractérisé par** un générateur de signal (12), conçu pour générer un premier signal micro-ondes (f_{MW1}(t)) pour le premier émetteur micro-ondes (10a), ledit signal présentant au moins deux composantes de fréquence, et pour générer un deuxième signal micro-ondes (f_{MW2}(t)) pour le deuxième émetteur micro-ondes (10b), ledit signal présentant au moins deux composantes de fréquence TT déphasées les unes par rapport aux autres, le générateur de signal (12), pour la formation du premier signal micro-ondes (f_{MW1}(t)), comprend un premier additionneur de puissance (20a), conçu pour additionner un premier signal micro-ondes modulé en fréquence (f_{MW1+}(t)) avec deux TT déphasées les unes par rapport aux autres et d'un autre premier signal micro-ondes modulé en fréquence (f_{MW1+}(t)) avec deux TT déphasées les unes par rapport aux autres, et le générateur de signal (12), pour la formation du deuxième signal micro-ondes (f_{Mw2}(t)), comprend un deuxième additionneur de puissance (20b), conçu pour additionner un deuxième signal micro-ondes modulé en fréquence (f_{MW2}-(t)) avec deux TT déphasées les unes par rapport aux autres et d'un autre second signal micro-ondes modulé en fréquence (f_{MW2+}(t)) avec deux TT déphasées les unes par rapport aux autres.

2. Gradiomètre de champ magnétique selon la revendication 1, dans lequel le générateur de signal (12) est conçu pour régler indépendamment la puissance du premier signal micro-ondes modulé en fréquence (f_{MW1+}(t)) et de l'autre premier signal micro-ondes modulé en fréquence (f_{MW1+}(t)), et dans lequel le générateur de signal (12) est conçu pour régler indépendamment la puissance du deuxième signal micro-ondes modulé en fréquence (f_{MW2}-(t)) et de l'autre deuxième signal micro-ondes modulé en fréquence (f_{MW2+}(t)).

3. Gradiomètre de champ magnétique selon l'une quelconque des revendications précédentes, dans lequel le générateur de signal (12), pour la formation du premier signal micro-ondes modulé en fréquence (f_{MW1-}(t)), comprend un premier mélangeur de fréquence (13a) pour le mélange en fréquence d'un signal modulé en fréquence (f_{SB}(t)) et d'un premier signal d'oscillateur (f_{MW1}(t)), et, pour la formation de l'autre premier signal micro-ondes modulé en fréquence (f_{MW1+}(t)), un autre premier mélangeur de fréquence (13a') pour le mélange en fréquence du signal modulé en fréquence (f_{SB}(t)) et d'un autre premier signal d'oscillateur (f_{MW1+}).

4. Gradiomètre de champ magnétique selon la revendication 3, dans lequel le générateur de signal (12) comporte au moins un atténuateur programmable (22) pour l'atténuation réglable d'une fraction respective de la puissance du signal micro-ondes modulé en fréquence (f_{SB}(t)) qui est fourni à un mélangeur de fréquence correspondant (13a, 13a').

5. Gradiomètre de champ magnétique selon la revendication 3 ou 4, dans lequel le générateur de signal (12) comporte un premier oscillateur (15a) pour générer le premier signal d'oscillateur (f_{MW-}), de préférence avec une puissance réglable, et un premier oscillateur supplémentaire (15a') pour générer le second signal d'oscillateur (f_{MW+}), de préférence avec une puissance réglable.

6. Gradiomètre de champ magnétique selon l'une quelconque des revendications précédentes, dans lequel le dispositif d'évaluation (11) comporte un premier démodulateur (16a) pour former un premier signal de double résonance démodulé (V_{LIA1}^{DR}) à partir de la lumière de fluorescence détectée (V_{FL1}(t)) de la première zone de mesure (3a) et un deuxième démodulateur (16b) pour former un deuxième signal de double résonance démodulé (V_{LIA2}^{DR}) à partir de la lumière de fluorescence détectée (V_{FLA2}(t)) de la deuxième zone de mesure (3b).

7. Gradiomètre de champ magnétique selon la revendication 6, dans lequel les deux démodulateurs (16a, b) sont conçus comme des amplificateurs lock-in.

8. Gradiomètre de champ magnétique selon la revendication 6 ou 7, dans lequel le dispositif d'évaluation (11) est conçu pour déterminer, à partir du premier signal de double résonance démodulé (V_{LIA1}^{DR}), une déviation de résonance dépendant du champ magnétique (Δ_{B}) d'un premier champ magnétique (Bₐ) dans la première zone de mesure (3a), et, à partir du deuxième signal de double résonance démodulé (V_{LIA2}^{DR}), déterminer une déviation de résonance dépendant du champ magnétique (ΔB) d'un deuxième champ magnétique (B_{b}) dans la deuxième zone de mesure (3b).

9. Gradiomètre de champ magnétique selon le préambule de la revendication 1, **caractérisé en ce que** le générateur de signal (12) comporte un premier additionneur de puissance (20a), conçu pour former un premier signal micro-ondes (f_{MW1}(t)) pour le premier émetteur micro-ondes (10a) par addition de deux premiers signaux micro-ondes modulés en fréquence (f_{MW1+}(t), f_{MW1-}(t)), que le générateur de signal (12) comporte un deuxième additionneur de puissance (20b), conçu pour former un deuxième signal micro-ondes (f_{MW2}(t)) pour le deuxième émetteur micro-ondes (10b) par addition de deux seconds signaux micro-ondes modulés en fréquence (f_{MW2+}(t), f_{MW2-}(t)), et que le dispositif d'évaluation (11) comporte un premier répartiteur de puissance (23a) conçu pour répartir la puissance de la lumière de fluorescence détectée (V_{FL1}(t)) provenant de la première zone de mesure (3a) sur une première paire de démodulateurs (16a, 16a') et un deuxième répartiteur de puissance (23b) conçu pour répartir la puissance de la lumière de fluorescence détectée (V_{FL2}(t)) provenant de la deuxième zone de mesure (3b) sur une seconde paire de démodulateurs (16b, 16b'), que le générateur de signal (12) est conçu pour générer les premiers signaux micro-ondes modulés en fréquence (f_{MW1+}(t), f_{MW1}-(t)) avec des fréquences porteuses respectivement différentes et les seconds signaux micro-ondes modulés en fréquence (f_{MW2+}(t), f_{MW2-}(t)) avec des fréquences porteuses respectivement différentes.
